# EUROPEAN PATENT SPECIFICATION

(11) **EP 1 468 302 B1**
(45) Date of publication and mention of the grant of the patent: **17.08.2005**
(21) Application number: 03700867.9
(22) Date of filing: 13.01.2003
(51) Int. Cl.: G01R 31/34

(54) **ELECTRIC MOTOR MONITORING SYSTEM**
ELEKTROMOTOR-ÜBERWACHUNGSSYSTEM
SYSTEME DE SURVEILLANCE POUR MOTEUR ELECTRIQUE

(30) Priority: 15.01.2002 GB 0200867
(43) Date of publication of application: 20.10.2004
(73) Proprietor: University Court of Glasgow Caledonian University, Glasgow G4 OBA (GB)
(72) Inventor: CULLEN, George, City Campus, Glasgow G4 0BA (GB); STEWART, Brian, City Campus, Glasgow G4 0BA (GB)
(74) Representative: Kennedy, David Anthony
(86) International application number: PCT/GB2003/000099
(87) International publication number: WO 2003/060536

(56) References cited:
- EP-A- 0 510 795
- US-A- 4 814 699
- US-A- 6 138 078
- HAESSLER H W ET AL: "A new measurement technique for the investigation of arcing processes of sliding contacts" PROCEEDINGS OF THE HOLM CONFERENCE ON ELECTRICAL CONTACTS. CHICAGO, OCT. 6 - 9, 1991, NEW YORK, IEEE, US, vol. CONF. 37, 6 October 1991 (1991-10-06), pages 153-155, XP010054555 ISBN: 0-7803-0231-1

## Description

The present invention relates to the field of monitoring devices for electric motors. In particular, it relates to an arcing event detection device that provides a means for monitoring, recording and diagnosing a variety of electric motor operating and fault conditions.

Accurate and reliable diagnostic measurements are of paramount importance in the application and control of DC and AC electric motors. The Prior Art teaches of various methods for measuring speed and torque associated with such motors that require the addition of mechanical or electrical components to the motor drive system.

A summary of conventional speed measurement systems taught in the Prior Art include:
1) Optical techniques whereby reflected light from rotating components is measured. Such systems require a reflective tape to be placed on the motor shaft. However, within industrial situations maintaining the signal integrity due to the detrimental effects of dirt, loss of connection, shaft vibration etc. becomes highly problematic.
2) Magnetic Pick-up Devices that employ the Hall effect to measure speed. These devices are susceptible to errors due to magnetic field variations and also require careful positioning on the motor.
3) Eddy Current Displacement Probes and Variable Reluctance Sensors that both require to be physically mounted close to irregular rotating components such as flats on the shaft or gear teeth. Like the Magnetic Pick-up Devices these probes and sensors require careful positioning and are susceptible to errors due to magnetic field variations around the electric motor.
4) Hand Held Tachometers that again require physical contact with the rotating shaft of the motor. However, when employed with low power motors the increased torque required during measurement can result in the motor speed being altered.
5) Back e.m.f where the back e.m.f. relates directly to the speed of the motor. Such measurement systems require direct user access to the associated motor power cables.

Similarly, conventional torque measurement systems taught in the Prior Art include:
1) Dynamometers, used to measure torque in rotating machinery. In general these devices are impractical to fit to motors once they have been integrated into a particular application.
2) Measurement of motor current that then allows an estimate of the torque to be calculated by employing motor performance characteristic curves. The major drawback to this technique is that it can be highly inaccurate due to fluctuations in load and speed of rotation.
3) Measurement of motor back e.m.f. Although the back e.m.f. varies with load it also depends on the motor speed therefore such a method is susceptible to erroneous readings.
4) Torque sensors and strain gauge sensors. Such measurement systems require direct user access to the associated motor shaft.

All of the above measurement methods are intrusive and require full access to the motor shaft, the power cables, or the load being driven by the motor. Such measurements often involve the removal of safety guards that can have obvious implications to user safety.

In addition, industrial plants may require to be stopped in order to allow installation of these speed and torque measurement devices with the effect of increasing the related maintenance costs. Many of these industrial plants employ large numbers of electric motors that require to be monitored. Therefore, it is often impractical and expensive to install speed and torque monitoring equipment on all the individual electric motors.

US Patent No. US 4,577,151 in the name Tanisaka et al. attempts to address some of the problematic features of the Prior Art as highlighted above. This document teaches of a spark monitor device, comprising of an antenna, which is suitable for receiving high frequency noise. The antenna then detects the high frequency signals associated with the sparks generated in a current collector of a rotary electric machine. Monitoring of the electric machine is then achieved by analysing the state of the spark generation on the basis of the product of a peak value of the high frequency noise exceeding a set predetermined value and a time interval during which the peak value exceeds the set predetermined value. This product value is calculated for every arcing event within the machine such that alarm signals are activated in response to each individual arcing event. The spark monitor device of Taniska is only applied to generators where no arcing is anticipated. Arcing, no matter how small, indicates a fault.

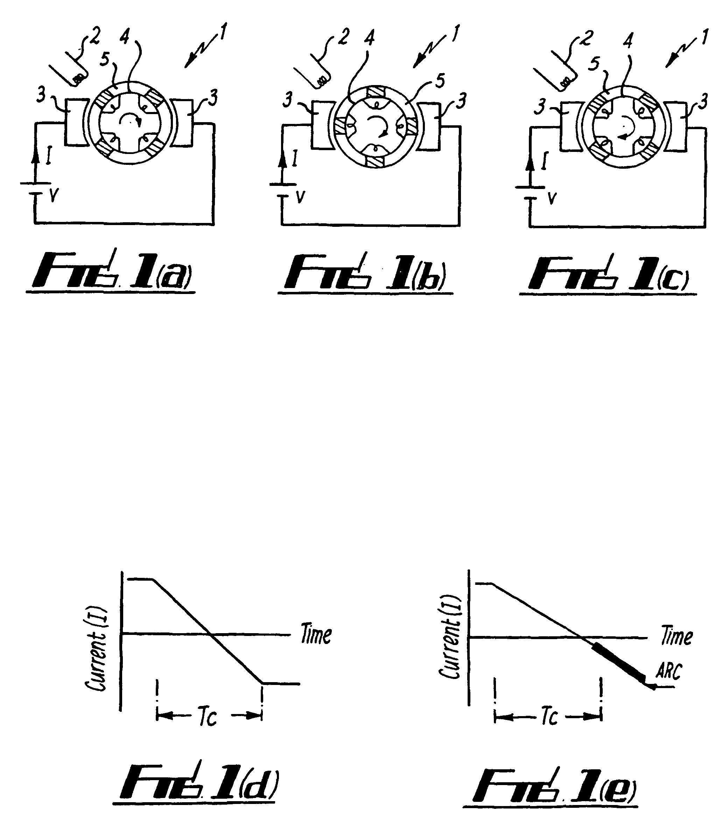

Figure 1 presents a simple two pole DC electric motor 1. The two pole DC electric motor 1 is shown in three different states of operation. From Figures 1(a), (b) and (c) it can be seen that the two pole DC electric motor 1 further comprises a motor field coil 2, two motor brushes 3, four armature coils 4 and a four sector commutator 5.

Figure 1(d) and (e) show the conditions of the current in one of the armature coils 4 as the commutator 5 passes under a brush 3 from which a constant current I amps flows. The current flowing through the armature coil 4 prior to commutation is +I/2 amps (corresponding to Figure 1(a)). During commutation the current in the coil 4 is effectively reversed to -I/2 amps (corresponding to Figure 1(c)). This process of current reversal takes time T_{c} seconds. If the current is fully reversed in time T_{c} then there will be no arcing at the brush contact 3 and the current versus time profile shall be as shown in Figure 1(d).

However, if the current is not fully reversed during time T_{c} the commutation time is extended by arcing at the trailing edge of the brush 3, as represented in Figure 1(e). This process is known in the art as under commutation. Arcing may also occur if the current reversal is too fast resulting in over-commutation producing arcs at the leading edge of the brush 3.

The following are a list of factors known to affect or influence the arcing characteristics of the electric motor, namely:
1) Inherent properties of the brushes. Different brush materials exhibit differing conduction properties and so affect the occurrence of arcing events. Fragmentation of the brush material results in electrical field stress enhancement points that again affect the likelihood of arcing. Sharper edges and greater brush dimensions both increase the chances of such fragmentation. In addition, the inherent shape or size of the brushes also influences arcing. Sharper edges result in increased current densities and thus an increased probability of the formation of an arc;
2) The work factor between the brush and the commutator materials also affects the strength of the electric field required to produce arcing. Ionisation voltages, hence arc formation, is found to be material dependent;
3) Mechanical vibrations within the electric motor affect the charge transfer and the production of fragments from the brush and the commutator. Thus mechanical vibrations within the electric motor directly affects the formation of the arcing event;
4) Inter segment capacitance and inductance affects the flow of charge from the directly connected and non-directly connected segments of the commutator. This factor affects the build up or dissipation of charge within the electric motor thus affecting the possibility of arcing occurring;
5) The purity and type of gas in the region of the brushes affects the ionisation potential and hence the influence of the arcs produced. In addition any gaseous discharge affects the composition of the gas in the region of the arc, producing charged and excited species that also affects the suppression or regeneration of discharge events;
6) Aerodynamic effects, such as turbulence around the brush contact area also acts to alter the gas density and hence the affects of the arc discharge;
7) Metallic components that become etched and fragments that evolve within the motor act to produce field stress enhancement points that also affect the arcing characteristics;
8) Commutating coil e.m.f. The time T_{c} during which a coil is short circuited is typically 2ms or less. The rate of current change is therefore very large, typically 100,000 Amps/second. Each armature coil will have an appreciable inductance, and hence during commutation an inductive e.m.f. is generated that acts to oppose the current reversal. This induced e.m.f increases the probability of arcing. Although interpoles or compoles can be employed to reduce the inductive e.m.f. they only act to reduce arcing when the motor is running in the steady state. It is found that motor transients still act to produce significant arcing events.
9) Winding Degradation. Winding insulation breakdown or failure can result in unexpected arcing or changes in arc characteristics.
10) Brush material. Brushes from various sources may have significantly different metallurgical properties, hence influencing arc formation and characteristics.
11) Motor drive systems. The method employed to power the machine e.g. Pulse Width Modulation, Direct DC and AC etc. will have an effect on the arcing properties.

Each of the factors outlined above affects the ability of an arc to form, the duration of the arc and the arc intensity. In general these arcing events are rather random in nature, the time duration typically varying between a few microseconds to several milliseconds. The arc is therefore essentially an impulse function with an associated broad band of frequencies in the range 0Hz to 1GHz.

It is these associated frequencies that result in television, radio and general communication interference. Such interference is generally unwanted and the Prior Art teaches of equipment designed at great expense to reduce such arcing events, usually with only limited success. Unlike the teachings of the Prior Art the present invention attempts to utilise these previously undesirable signals in order to provide a means for measuring a range of DC and AC electric motor/machine diagnostics including motor speed and torque.

The teachings of Tanisaka et al. exhibit certain inherent theoretical and practical problematic features. Most importantly the teachings are limited to the counting of the occurrence of sparking events. The described apparatus does not offer any facilities for relating an arcing event to a particular mechanical or electrical component within the electric motor. Similarly, there is no facility for physically locating the individual arcing events thus, information regarding the deterioration or alignment faults of the component parts of the electric motor cannot be extracted.

In addition, it can be shown that the relationship between the amplitude of a spark and the applied torque is non linear. The width of the spark can also be shown to be directly proportional to the applied force. Therefore, the system as taught by Tanisaka et al. will only work where the electric motor is operating under a constant load. Fluctuations in the load would lead to false alarm signals being generated.

A third major drawback of the teachings of Tanisaka et al is the fact that in industrial environments, there can be significant levels of background electrical noise generated from a variety of sources e.g. during the opening and closing of relays and electric contacts. Tanisaka's et al method has no way of discriminating between arcing within motors and external noise. Therefore, the presence of such external noise will again result in false alarms.

The teachings of Tanisaka et al also indicate that the sparking on current collectors is an irregular low frequency event. Therefore, their device is limited to use with generators where arcing only occasionally occurs. However, as outlined in detail above, it is now known in the Art that arcing is always present in mechanically commutated machines and so arcing signals are regularly produced as the electric motor operates.

The document US 6 452 416 B1 relates to an abnormality detecting apparatus for a rotating electric machine.

It is an object of an aspect of the present invention to provide an electric motor monitoring system for the detection of high frequency arcing events that provides a facility for measuring a range of motor diagnostics.

A further object of an aspect of the present invention is to provide an electric motor monitoring system for the detection of high frequency arcing events that provides a facility for locating and identifying electrical and mechanical faults within the electric motor.

It is a further object of an aspect of the present invention to provide an electric motor monitoring system for the detection of high frequency arcing events that provides a facility for optimising the alignment and monitoring the efficiency of the electrical and mechanical components of the electric motor.

A yet further object of an aspect of the present invention is to provide an electric monitoring system for the detection of high frequency arcing events that is capable of suppressing background electrical noise so improving the signal to noise ratio of the detected signals.

According to a first aspect of the present invention there is provided an electric motor monitoring system comprising an antenna, a data sampling means and a data processing means and the system provides a diagnostic for monitoring the operation of both mechanical and electrical components of the electric motor, wherein the antenna provides means for detecting a radio-frequency signal generated by arcing events from a brush contact of the electric motor.

Preferably the antenna comprises a means for screening background noise so improving the overall signal to noise ratio of the electric motor monitoring system.

Preferably the antenna further comprises a frequency matching unit, wherein the frequency matching unit allows the antenna to be frequency tuned so as to optimise its operation with the electric motor.

Optionally the frequency matching unit comprises a signal conditioning unit.

Optionally the antenna comprises a balanced Faraday screened loop antenna. Alternatively the antenna comprises an unbalanced Faraday screened loop antenna.

Optionally the antenna comprises an electric field probe or a magnetic field probe.

Preferably the data sampling means comprises an anti aliasing filter, an analogue to digital converter and a high speed PCI card wherein the data sampling means allows the high frequency signal, over a predetermined length of time, to be captured.

Preferably the data processing means comprises a computer processor capable of manipulating and storing the captured data.

According to a second aspect of the present invention there is provided an antenna for measuring high frequency signals associated with arcing events in an electric motor, comprising a loop and a loop screen, wherein the loop screen shields the loop from background noise thus improving the signal to noise ratio of the signal detected by the antenna, wherein the loop screen physically covers all but a small detection section of the loop.

Preferably the antenna further comprises a frequency matching unit, wherein the frequency matching unit allows the antenna to be frequency tuned so as to optimise the antenna's operation with the electric motor.

Optionally the frequency matching unit comprises a signal conditioning unit.

Preferably the loop comprises a conductor and a screened coaxial cable wherein the conductor is turned back on itself so as to form one or more turns, the end of the conductor cable being attached to the screen of the coaxial cable.

According to a third aspect of the present invention there is provided a diagnostic method for monitoring both mechanical and electrical components associated with an electric motor, comprising the steps of:
1) Detection of high frequency radio frequency signals associated with arcing events within the electric motor;
2) Sampling the high frequency signal over a predetermined length of time;
3) Processing the sampled data so as to provide information regarding the mechanical and electrical components of the electric motor.

Preferably the diagnostic method provides a means for associating the frequency of the high frequency signal to individual components of the electric motor.

Most preferably the detection of the high frequency signals employs a non-intrusive antenna.

Preferably the sampling provides a means for monitoring frequency modulation and amplitude modulation within the high frequency signals.

Preferably the processing of the sampled data comprises Fast Fourier Transformations applied to the sampled data so as to convert the sampled data to interpretable frequency spectra.

Alternatively the processing of the sampled data comprises Wavelet Analyses or some other Digital Signal Processing technique applied to the sampled data so as to convert the sampled data to interpretable frequency spectra.

Most preferably the interpretable frequency spectra comprise frequency features that can be directly associated with particular diagnostics of the mechanical or electrical components of the electric motor.

Preferably the interpretable frequency spectra comprise frequency features that can be directly associated with particular mechanical or electrical faults of the electric motor.

Alternatively the processing of the sampled data comprises calculating an average width of the high frequency signals, above a predetermined level, over a number of arcing events.

Alternatively the processing of the sampled data comprises calculating an average height of the high frequency signals over a number of arcing events.

Alternatively the processing of the sampled data comprises calculating an average ratio of the width and height of the high frequency signals over a number of arcing events.

Optionally the method for monitoring the diagnostics of the mechanical and electrical components of the electric motor further comprises a step of self calibration of the diagnostic method.

Preferably the self calibration of the diagnostic method comprises a current measuring technique involving the steps of:
1) Measuring the torque on the electric motor by employing the non-intrusive antenna;
2) Measuring directly the current in the electric motor so as to enable the torque on the electric motor to be calculated;
3) Taking the difference between the two methods for obtaining the value of the torque on the electric motor so providing a compensation factor; and
4) Adding the compensation factor to the non-intrusive antenna method for measuring the torque on the electric motor.

Embodiments of the present invention will now be described by way of example only with reference to the accompanying figures, in which:
Figure 1 presents a schematic illustration of a standard two pole DC electric motor within which are generated arcing signals;
Figure 2 presents a schematic illustration of an electric motor monitoring system in accordance with the present invention;
Figure 3 presents a schematic illustration of a screened loop antenna employed by the electric motor monitoring system of Figure 2;
Figure 4 presents a measured output signal from the electric motor monitoring system where the system employs:
   a) a commercially available antenna;
   b) the screened loop antenna of Figure 3.
Figure 5 schematically presents the electric motor monitoring system employed to measure the speed of the electric motor;
Figure 6 schematically presents the electric motor monitoring system employed to estimate the applied load on the electric motor by evaluating:
   a) the width of the high frequency arcing events;
   b) the Route Means Square (RMS) or other statistical type measurement of the high frequency arcing events;
Figure 7 schematically presents the electric motor monitoring system employed to measure frequency modulations or the arcing events within the electric motor;
Figure 8 schematically presents the electric motor monitoring system employed to measure amplitude modulations of the arcing events within the electric motor;
Figure 9 schematically presents the electric motor monitoring system employed to measure several of the aforementioned diagnostics of the electric motor simultaneously; and
Figure 10 presents a schematic illustration of a current measurement technique employed to calibrate the electric motor monitoring system.

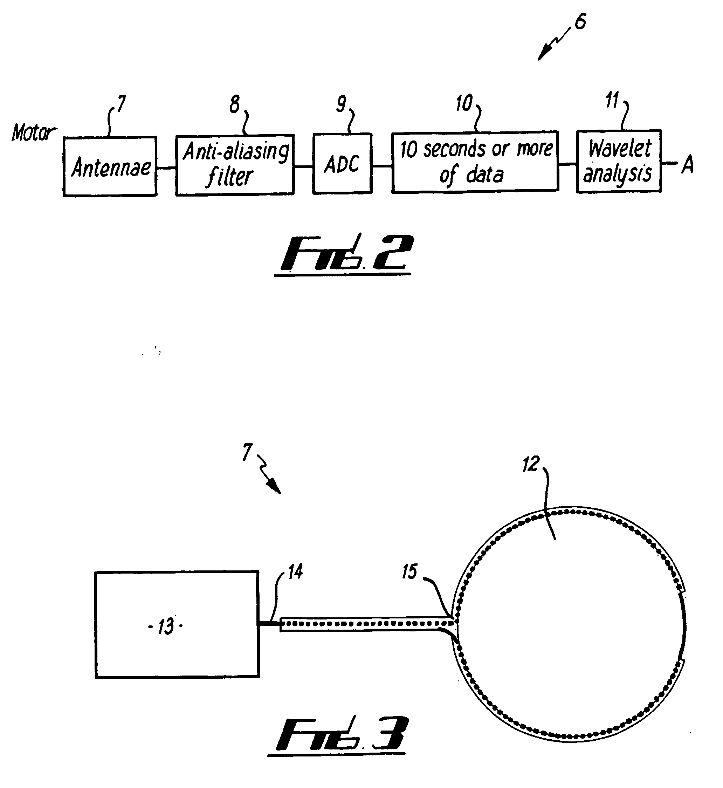

Figure 2 presents a schematic illustration of an electric motor monitoring system, generally depicted at 6. The electric motor monitoring system 6 employs a computer interfacing and data acquisition method to capture and process arcing events within an electric motor 1. The electric motor monitoring system 6 can be seen to comprise a balanced screened loop antenna 7 that includes a matching and signal conditioning unit (not shown), an anti aliasing filter 8, an analogue to digital signal converter (ADC) 9, a high speed PCI card 10 and a computer processor 11 for analysing the sampled data. In an alternative embodiment the electric motor monitoring system 6 further comprises an amplifier (not shown). The high speed PCI card 10 is capable of capturing and saving several million points of data to the computer processor 11 for subsequent analysis. The further processing required depends on what particular parameter requires to be measured, as described in further detail below.

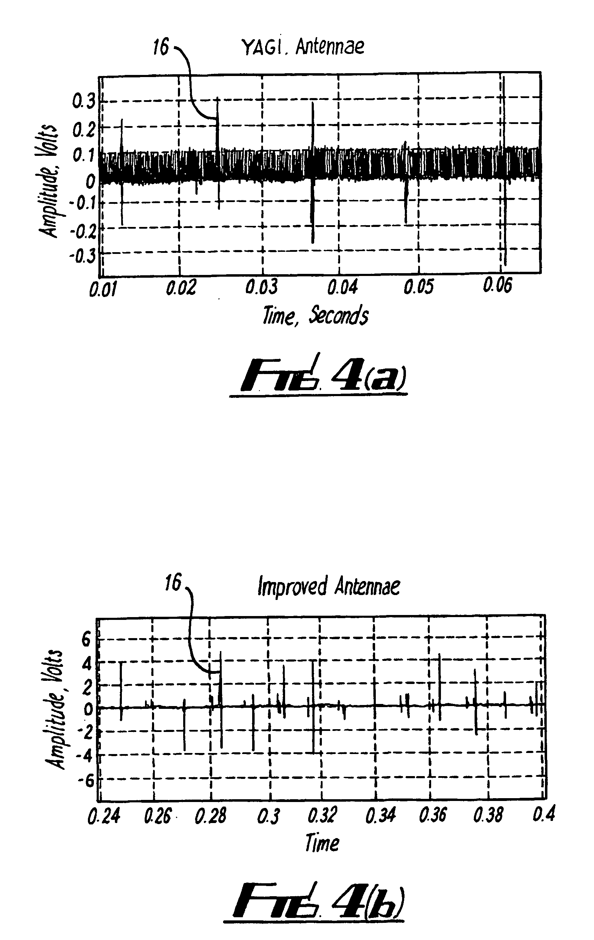

Detail of the balanced screened loop antenna 7 is provided in Figure 3. The balanced screened loop antenna 7 comprises a loop section 12 and a frequency matching tuning unit 13. The loop section 12 is constructed from a conductor 14 and a screened coaxial cable 15. The conductor 14 is arranged such that it loops back on itself with the end being attached to the screen of the coaxial cable 15 at the start of the loop section 12. The screen of the coaxial cable 15 is deployed such that it extends in two directions from the start of the loop section 12 with a small gap being left at the far end.

Employing the frequency matching tuning unit 13 allows the electric motor monitoring system 6 to be optimised for use with a particular electric motor 1 or to be altered for frequency selectivity for use with multiple electric motors. Optimising the frequency selection of the balanced screened loop antenna 7 for a particular electric motor design and geometry has the advantage of optimising the arcing event signal characteristics for the particular fault conditions as outlined below.

In an alternative embodiment it is possible to employ an unbalanced screened loop antenna or a multi-turn screened loop antenna (not shown). The multi-turn screened loop antenna comprises a number of screen coiled loops with a small gap in the cable screen being at the furthest point of the coiled loops.

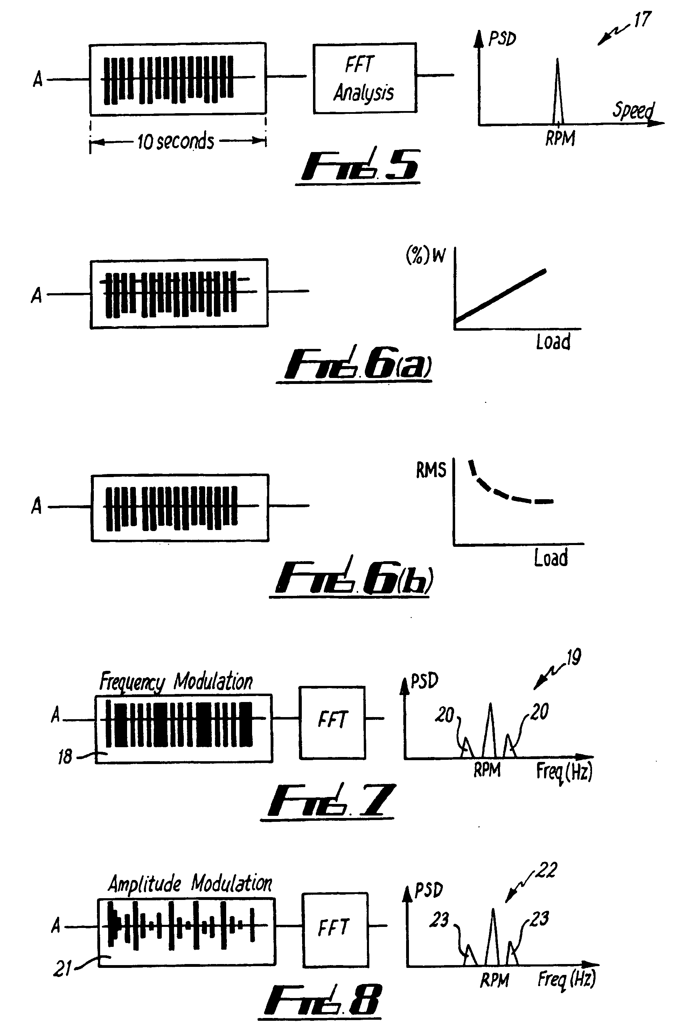

Figure 4 highlights the significant advantage of employing the balanced screened loop antenna 7 over those previously described in the Prior Art. Antennas employed in the Prior Art are designed to receive continuous broadcast signals. Therefore, employing such an antenna with the present system provides a measured RF signal that is a combination of both the desired electric motor signal and any unwanted broadcast signal as shown in Figure 4(a).

A further problem of employing the antennas taught in the Prior Art for such a measurement is their susceptibility to ringing when an RF impulse is received. The antenna inductance, stray capacitance and the associated receiver input impedance circuitry create a tuned circuit that can cause prolonged ringing. The duration of the prolonged ringing becomes problematic if the antenna is used to measure the speed of an electric motor (as described below). Ideally it desired that antenna signal oscillations should be completely damped before the next arcing event occurs.

Employing the balanced screened loop antenna 7 significantly reduces these problematic features. As seen in Figure 4(b), the signal to noise ratio of the measured RF signal is greatly improved by employing the balanced screened loop antenna 7. Here the arcing events 16, as the commutator 5 crosses the brushes, are clear. There are two very close arcing events 16 due to the arcing on each brush occurring at slightly different times. Thus, as described in the Prior Art, if the number of segments on the commutator 5 is known the speed of the electric motor 1 can be calculated.

Further improvements to the signal to noise ratio of the signal detected by the electric motor monitoring system 6 can be achieved by converting the high frequency signals to low frequency signals using standard heterodyne techniques, as known in the art, prior to the described signal processing techniques.

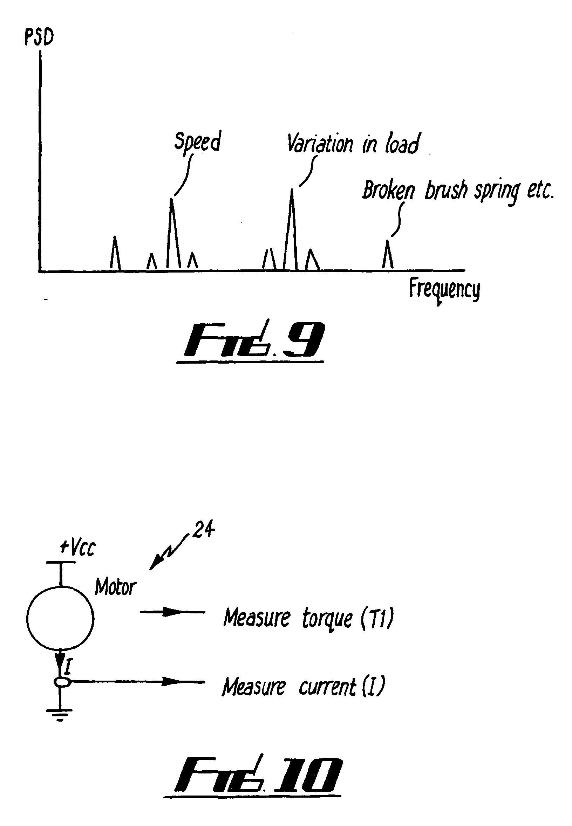

Alternatively, the ADC 9, high speed PCI card 10 and computer processor 11 can be employed to calculate the speed of the electric motor 1. Fast Fourier Transform (FFT) techniques are employed so as to convert the detected arcing events 16 so as to provide information regarding rotational speed. Figure 5 schematically presents the FFT carried out by the electric motor monitoring system 6 with the resultant speed representation depicted at 17.

Further processing techniques, carried out by the ADC 9, the high speed PCI card 10 and computer processor 11 provide estimates of the applied load or torque on the electric motor 1. It is found that a percentage of the detected arcing event signal, above a comparator level, is directly proportional to the applied load or torque. Therefore, by calculating the average width of the arcing event signal, over several thousand arcing events 16, provides a measure of the applied load or torque on the electric motor 1. The relationship between the width of the arcing event 16 and the applied load or torque is presented in Figure 6(a).

It is also found that there is an inverse proportional relationship between the RMS height of the arcing events 16 and the applied load or torque. Thus, the ADC 9, high speed PCI card 10 and computer processor 11 are employed to calculate RMS height so providing a means for analysing the relationship with the applied load or torque, see Figure 6(b).

In addition to the relationships between the arcing events 16 and the applied load or torque it is found that the ratio of the width to height is sensitive to load or torque variations. Therefore, calculating the width to height ratio provides an ideal diagnostic for monitoring such variations in the applied load or torque.

The aforementioned techniques for calculating applied load or torque provide ideal means for testing the functionality of suppression of components such as interpoles or compoles (not shown) within the electric motor 1. A failure of one of these components would alter both the height and the width of the arcing event 16 and so would show up on the graphs of Figure 6.

Both the condition of the brushes, commutators and flashover fault conditions, that can result in arcing extending between commutator segments of the electric motor 1, can be monitored using the same techniques. Changes due to degradation on the brushes ant the commutators will affect the height and frequency of the arcing event signal and so would again show up on the graphs of Figure 6.

Employment of the FFT techniques provides a further embodiment for measuring diagnostics of the electric motor 1 as outlined in Figure 7. Using the ADC 9 and the high speed PCI card 10 a frequency modulated data sample 18 can be obtained. FFT of this data sample 18 by the computer processor 11 provides a frequency spectrum 19 with side bands 20. These frequency side bands 20 are indicative of variations in the speed of the motor 1 produced by faults such as slipping belts, eccentric gearing etc.

The described embodiment of the electric motor monitoring system 6 also provides a means for evaluating possible mechanical eccentricity variations on the axis of rotation of the electric motor 1. This may be carried out both at the installation stage as well as during servicing of the motor 1 so allow the efficiency of the electric motor 1 to be optimised.

A similar technique is employed to monitor the amplitude modulation of the arcing events 16, as outlined in Figure 8. FFT of an amplitude modulated data sample 21 produces a frequency spectrum 22 with side bands 23 that are indicative of friction variations within the motor e.g. within the bearings, in the clutch mechanism, or due to imbalances in the load etc.

The aforementioned electric motor diagnostics have been described in isolation for clarity purposes. However, due to the nature of FFT it is possible to measure combinations of these diagnostics simultaneously as outlined in Figure 9. Employing appropriate software processing allows different faults known to occur within electric motors 1 to be distinguished e.g. broken brushes, wear in the commutator, excessive vibrations, eccentricity problems etc. Different frequency spectrum components and magnitudes of these components from the captured data sample may be appropriately filtered to isolate the fault condition.

A further embodiment of the electric motor monitoring system 6 employs a current measuring technique 24, as shown in Figure 10, for calibrating the electric motor monitoring system 6. Calibration employs the RF antenna torque measuring technique (T1) as described in Figure 6(a) and the measurement of the current I through the electric motor 1. By multiplying the measured current I by the torque constant K, that is an inherent property of the electric motor 1, an estimate for the applied torque (T2) is obtained. Ideally these two methods should provide the same value for the applied torque. Any difference between these values is indicative of contamination within the motor 1 thus, the offset (T2-T1) can thereafter be added to the T1 torque value to compensate for any contamination.

The described electric motor monitoring system 6 is an ideal means for testing an electric motor 1 at the end of a manufacturing process. It provides for checking the functionality of the interpoles, decoupling capacitors and for identifying obvious manufacturing faults such as poor connectors.

The present invention offers several inherent advantages over the Prior Art. It can be employed to measure speed, acceleration and torque of the associated the electric motor 1. Employment of the balanced screened loop antenna 7 significantly improves the signal to noise ratio of the RF detected signals and so provides more accurate readings of these diagnostics.

A second advantage of the present invention is that the employment of FFT techniques provides a means for measuring and locating both electrical and mechanical faults within the electric motor 1.

A further advantage of the present invention is that it provides an electric motor monitoring system 6 that provides portable, adjustable and non-intrusive measurement of various diagnostics of the electric motor 1. Therefore, the electric motor monitoring system 6 does not require the electric motor 1 to be stopped for installation purposes. In addition, where it is required to monitor a large number of electric motors it is possible to employ the same system that can simply be located and frequency matched, in turn, to each individual electric motor.

A yet further advantage of the electric motor monitoring system 6 is that when used in conjunction with standard torque measurement techniques it provides a means for self calibration and compensation to take account of contamination within the electric motor 1.

Further modifications or improvements may be incorporated without departing from the scope of the invention as defined in the claims.

## Claims

1. An electric motor monitoring system comprising an antenna, a data sampling means and a data processing means and the system provides a diagnostic for monitoring the operation of both mechanical and electrical components of the electric motor **characterised in that** the antenna provides means for detecting a radio-frequency signal generated by arcing events from a brush contact of the electric motor.

2. An electric motor monitoring system as claimed in Claim 1 wherein the antenna comprises a means for screening background noise so improving the overall signal to noise ratio of the electric motor monitoring system.

3. An electric motor monitoring system as claimed in Claim 1 or Claim 2 wherein the antenna further comprises a frequency matching unit such that the frequency matching unit allows the antenna to be frequency tuned so as to optimise its operation with the electric motor.

4. An electric motor monitoring system as claimed in Claim 4 wherein the frequency matching unit comprises a signal conditioning unit.

5. An electric motor monitoring system as claimed in any of the preceding Claims wherein the antenna comprises a balanced Faraday screened loop antenna.

6. An electric motor monitoring system as claimed in claim 1 to 4 wherein the antenna comprises an unbalanced Faraday screened loop antenna.

7. An electric motor monitoring system as claimed in any of the preceding Claims wherein the antenna comprises an electric field probe or a magnetic field probe.

8. An electric motor monitoring system as claimed in any of the preceding Claims wherein the data sampling means comprises an anti aliasing filter, an analogue to digital converter and a high speed PCI card such the data sampling means allows the high frequency signal, over a predetermined length of time, to be captured.

9. An electric motor monitoring system as claimed in Claim 8 wherein the data processing means further comprises a computer processor capable of manipulating and storing the captured data.

10. An antenna for measuring high frequency radio frequency signals associated with arcing events from a brush contact in an electric motor, the antenna comprising a loop and a loop screen, wherein the loop screen shields the loop from background noise thus improving the signal to noise ratio of the signal detected by the antenna **characterised in that** the loop screen physically covers all but a small detection section of the loop.

11. An antenna as claimed in Claim 10 wherein the antenna further comprises a frequency matching unit such that the frequency matching unit allows the antenna to be frequency tuned so as to optimise the antenna's operation with the electric motor.

12. An antenna as claimed in Claim 11 wherein the frequency matching unit comprises a signal conditioning unit.

13. An antenna as claimed in any of Claims 10 to 12 wherein the loop comprises a conductor and a screened coaxial cable such that the conductor is turned back on itself so as to form one or more turns while the end of the conductor cable is attached to the screen of the coaxial cable.

14. A diagnostic method for monitoring the operation of both mechanical and electrical components associated with an electric motor, the method comprising the steps of:
i) Detecting high frequency radio frequency signals associated with arcing events from a brush contact within the electric motor;
ii) sampling the high frequency signal over a predetermined length of time;
iii) Processing the sampled data so as to provide information regarding the mechanical and electrical components of the electric motor.

15. A diagnostic method according to Claim 14 wherein the method provides a means for associating the frequency of the high frequency signal to individual components of the electric motor.

16. A diagnostic method according to Claim 14 or Claim 16 wherein the detection of the high frequency signals employs a non-intrusive antenna.

17. A diagnostic method according to any of Claims 14 to 16 wherein the sampling provides a means for monitoring frequency modulation and amplitude modulation within the high frequency signals.

18. A diagnostic method according to any of Claims 14 to 17 wherein the processing of the sampled data comprises the application of Fast Fourier Transformations so as to convert the sampled data to interpretable frequency spectra.

19. A diagnostic method according to any of Claims 14 to 17 wherein the processing of the sampled data comprises the application of Digital Signal Processing techniques to the sampled data so as to convert the sampled data to interpretable frequency spectra.

20. A diagnostic method according to Claim 19 wherein the Digital Signal Processing techniques comprise Wavelet Analysis.

21. A diagnostic method according to any of Claims 18 to 20 wherein the interpretable frequency spectra comprise frequency features that can be directly associated with particular diagnostics of the mechanical or electrical components of the electric motor.

22. A diagnostic method according to any of Claims 18 to 21 wherein the interpretable frequency spectra comprise frequency features that can be directly associated with particular mechanical or electrical faults of the electric motor.

23. A diagnostic method according to any of Claims 14 to 17 wherein the processing of the sampled data comprises calculating an average width of the high frequency signals, above a predetermined level, over a number of arcing events.

24. A diagnostic method according to any of Claims 14 to 17 wherein the processing of the sampled data comprises calculating an average height of the high frequency signals over a number of arcing events.

25. A diagnostic method according to any of Claims 14 to 17 wherein the processing of the sampled data comprises calculating an average ratio of the width and height of the high frequency signals over a number of arcing events.

26. A diagnostic method according to any of Claims 14 to 25 wherein the method comprises a step of self-calibration of the diagnostic method.

27. A diagnostic method according to Claim 26 wherein the self-calibration of the diagnostic method comprises a current measuring technique including the sub-steps of:
i) Measuring the torque on the electric motor by employing the non-intrusive antenna;
ii) Measuring directly the current in the electric motor so as to enable the torque on the electric motor to be calculated;
iii) Taking the difference between the two methods for obtaining the value of the torque on the electric motor so providing a compensation factor; and
iv) Adding the compensation factor to the non-intrusive antenna method for measuring the torque on the electric motor.

## Patentansprüche

1. Elektromotor-Überwachungssystem, das eine Antenne, ein Datenaufnahmemittel und ein Datenverarbeitungsmittel umfasst und wobei das System ein Diagnoseprogramm für die Überwachung des Betriebs der mechanischen und der elektrischen Bauteile des Elektromotors bereitstellt, **dadurch gekennzeichnet, dass** die Antenne Mittel für die Detektion eines Radiofrequenzsignals vorsieht, das von Lichtbogenbildungsereignissen durch einen Bürstenkontakt des Elektromotors erzeugt wird.

2. Elektromotor-Überwachungssystem nach Anspruch 1, bei dem die Antenne ein Mittel zum Abschirmen von Hintergrundrauschen umfasst, wodurch der Gesamt-Störabstand des Elektromotor-Überwachungssystems verbessert wird.

3. Elektromotor-Überwachungssystem nach Anspruch 1 oder Anspruch 2, bei dem die Antenne ferner eine Frequenzabgleicheinheit umfasst, sodass die Frequenzabgleicheinheit es zulässt, dass die Antenne frequenzabgestimmt wird, um ihren Betrieb mit dem Elektromotor zu optimieren.

4. Elektromotor-Überwachungssystem nach Anspruch 3, bei dem die Frequenzabgleicheinheit eine Signalaufbereitungseinheit umfasst.

5. Elektromotor-Überwachungssystem nach einem der vorhergehenden Ansprüche, bei dem die Antenne eine symmetrische durch Faraday-Käfig geschirmte Rahmenantenne umfasst.

6. Elektromotor-Überwachungssystem nach einem der Ansprüche 1 bis 4, bei dem die Antenne eine unsymmetrische durch Faraday-Käfig geschirmte Rahmenantenne umfasst.

7. Elektromotor-Überwachungssystem nach einem der vorhergehenden Ansprüche, bei dem die Antenne eine E-Feld-Sonde oder eine Magnetfeldsonde umfasst.

8. Elektromotor-Überwachungssystem nach einem der vorhergehenden Ansprüche, bei dem das Datenaufnahmemittel ein Anti-Aliasing-Filter, einen Analog-Digital-Wandler und eine High-Speed-PCI-Karte für hohe Übertragungsgeschwindigkeiten umfasst, sodass das Datenaufnahmemittel die Erfassung des Hochfrequenzsignals über einen vorbestimmten Zeitabschnitt zulässt.

9. Elektromotor-Überwachungssystem nach Anspruch 8, bei dem das Datenverarbeitungsmittel ferner einen Computerprozessor umfasst, der die erfassten Daten manipulieren und speichern kann.

10. Antenne zum Messen von mit Lichtbogenbildungsereignissen durch einen Bürstenkontakt in einem Elektromotor assoziierten Hochfrequenz-Radiofrequenzsignalen, wobei die Antenne eine Schleife und eine Schleifenabschirmung umfasst, bei der die Schleifenabschirmung die Schleife gegen Hintergrundrauschen abschirmt, sodass **dadurch** der Störabstand des von der Antenne detektierten Signals verbessert wird, **dadurch gekennzeichnet, dass** die Schleifenabschirmung physikalisch die ganze Schleife außer einem kleinen Detektionsabschnitt bedeckt.

11. Antenne nach Anspruch 10, wobei die Antenne ferner eine Frequenzabgleicheinheit umfasst, sodass die Frequenzabgleicheinheit es zulässt, dass die Antenne frequenzabgestimmt wird, um den Betrieb der Antenne mit dem Elektromotor zu optimieren.

12. Antenne nach Anspruch 11, bei der die Frequenzabstimmungseinheit eine Signalaufbereitungseinheit umfasst.

13. Antenne nach einem der Ansprüche 10 bis 12, bei der die Schleife einen Leiter und ein abgeschirmtes Koaxialkabel umfasst, sodass der Leiter auf sich zurückgewendet ist, um wenigstens eine Windung zu bilden, während das Ende des Leiterkabels an der Abschirmung des Koaxialkabels angebracht ist.

14. Diagnoseverfahren zum Überwachen des Betriebs der mit einem Elektromotor assoziierten mechanischen und elektrischen Bauteile, wobei das Verfahren die folgenden Schritte umfasst:
i) Detektion von mit Lichtbogenbildungsereignissen durch einen Bürstenkontakt in dem Elektromotor assoziierten Hochfrequenz-Radiofrequenzsignalen;
ii) Abtasten des Hochfrequenzsignals über einen vorbestimmten Zeitabschnitt;
iii) Verarbeiten der abgetasteten Daten, um Informationen bezüglich der mechanischen und elektrischen Bauteile des Elektromotors zu ergeben;

15. Diagnoseverfahren nach Anspruch 14, wobei das Verfahren ein Mittel zum Zuordnen der Frequenz des Hochfrequenzsignals zu einzelnen Bauteilen des Elektromotors vorsieht.

16. Diagnoseverfahren nach Anspruch 14 oder Anspruch 15, bei dem die Detektion des Hochfrequenzsignals eine berührungslose Antenne einsetzt.

17. Diagnoseverfahren nach einem der Ansprüche 14 bis 16, bei dem das Abtasten ein Mittel zum Überwachen von Frequenzmodulation und Amplitudenmodulation in den Hochfrequenzsignalen bereitstellt.

18. Diagnoseverfahren nach einem der Ansprüche 14 bis 17, bei dem das Verarbeiten der abgetasteten Daten die Anwendung von Fast-Fourier-Transformationen umfasst, um die abgetasteten Daten in interpretierbare Frequenzspektren umzusetzen.

19. Diagnoseverfahren nach einem der Ansprüche 14 bis 17, bei dem das Verarbeiten der abgetasteten Daten die Anwendung von Methoden der digitalen Signalverarbeitung auf die abgetasteten Daten umfasst, um die abgetasteten Daten in interpretierbare Frequenzspektren umzusetzen.

20. Diagnoseverfahren nach Anspruch 19, bei dem die Methoden der digitalen Signalverarbeitung die Wavelet-Analyse umfassen.

21. Diagnoseverfahren nach einem der Ansprüche 18 bis 20, bei dem die interpretierbaren Frequenzspektren Frequenzmerkmale aufweisen, die bestimmten Diagnoseprogrammen der mechanischen oder elektrischen Bauteile des Elektromotors direkt zugeordnet werden können.

22. Diagnoseverfahren nach einem der Ansprüche 18 bis 21, bei dem die interpretierbaren Frequenzspektren Frequenzmerkmale aufweisen, die bestimmten mechanischen oder elektrischen Störungen des Elektromotors direkt zugeordnet werden können.

23. Diagnoseverfahren nach einem der Ansprüche 14 bis 17, bei dem die Verarbeitung der abgetasteten Daten das Berechnen einer Durchschnittsbreite der Hochfrequenzsignale oberhalb eines vorbestimmten Pegels über eine Anzahl von Lichtbogenbildungsereignissen umfasst.

24. Diagnoseverfahren nach einem der Ansprüche 14 bis 17, bei dem die Verarbeitung der abgetasteten Daten das Berechnen einer Durchschnittshöhe der Hochfrequenzsignale über eine Anzahl von Lichtbogenbildungsereignissen umfasst.

25. Diagnoseverfahren nach einem der Ansprüche 14 bis 17, bei dem die Verarbeitung der abgetasteten Daten das Berechnen eines Durchschnittsverhältnisses der Breite und Höhe der Hochfrequenzsignale über eine Anzahl von Lichtbogenbildungsereignissen umfasst.

26. Diagnoseverfahren nach einem der Ansprüche 14 bis 25, wobei das Verfahren einen Schritt der Eigenkalibrierung des Diagnoseverfahrens umfasst.

27. Diagnoseverfahren nach Anspruch 26, bei dem die Eigenkalibrierung des Diagnoseverfahrens eine Strommessmethode umfasst, die die folgenden Teilschritte hat:
i) Messen des Drehmoments an dem Elektromotor durch den Einsatz einer berührungsfreien Antenne;
ii) Direktes Messen des Stroms in dem Elektromotor, um das Berechnen des Drehmoments an dem Elektromotor zu ermöglichen;
iii) Benutzen der Differenz zwischen den zwei Verfahren zum Erhalten des Wertes des Drehmoments an dem Elektromotor, wodurch ein Kompensationsfaktor bereitgestellt wird; und
iv) Addieren des Kompensationsfaktors zu dem Verfahren der berührungsfreien Antenne zum Messen des Drehmoments an dem Elektromotor.

## Revendications

1. Système de contrôle de moteur électrique comprenant une antenne, un moyen d'échantillonnage de données et un moyen de traitement de données et le système fournit un diagnostic pour contrôler le fonctionnement des composants mécaniques et électriques du moteur électrique, **caractérisé en ce que** l'antenne fournit un moyen pour détecter un signal radioélectrique généré par des événements d'arc provenant d'un contact des balais du moteur électrique.

2. Système de contrôle de moteur électrique suivant la revendication 1 dans lequel l'antenne comprend un moyen pour faire écran au bruit de fond, améliorant ainsi le rapport signal/bruit global du système de contrôle de moteur électrique.

3. Système de contrôle de moteur électrique suivant la revendication 1 ou 2 dans lequel l'antenne comprend en outre une unité d'adaptation de fréquence de sorte que l'unité d'adaptation de fréquence permet que l'antenne soit réglée en fréquence de manière à optimiser son fonctionnement en fonction du moteur électrique.

4. Système de contrôle de moteur électrique suivant la revendication 3 dans lequel l'unité d'adaptation de fréquence comprend une unité de mise en forme de signaux.

5. Système de contrôle de moteur électrique suivant l'une quelconque des revendications précédentes dans lequel l'antenne comprend une antenne cadre à écran de Faraday symétrique.

6. Système de contrôle de moteur électrique suivant l'une quelconque des revendications 1 à 4 dans lequel l'antenne comprend une antenne cadre à écran de Faraday asymétrique.

7. Système de contrôle de moteur électrique suivant l'une quelconque des revendications précédentes dans lequel l'antenne comprend une sonde de champ électrique ou une sonde de champ magnétique.

8. Système de contrôle de moteur électrique suivant l'une quelconque des revendications précédentes dans lequel le moyen d'échantillonnage de données comprend un filtre antirepliement de spectre, un convertisseur analogique/numérique et une carte PCI rapide de sorte que le moyen d'échantillonnage de données permet que le signal à haute fréquence soit, sur un laps de temps prédéterminé, capturé.

9. Système de contrôle de moteur électrique suivant la revendication 8 dans lequel le moyen de traitement de données comprend en outre un processeur d'ordinateur capable de manipuler et de stocker les données capturées.

10. Antenne pour mesurer des signaux radioélectriques à haute fréquence associés à des événements d'arc provenant d'un contact des balais dans un moteur électrique, l'antenne comprenant un cadre et un écran de cadre, dans laquelle l'écran de cadre protège le cadre du bruit de fond, améliorant ainsi le rapport signal/bruit du signal détecté par l'antenne, **caractérisée en ce que** l'écran de cadre couvre physiquement l'ensemble du cadre, à l'exception d'une petite section de détection.

11. Antenne suivant la revendication 10 dans laquelle l'antenne comprend en outre une unité d'adaptation de fréquence de sorte que l'unité d'adaptation de fréquence permet que l'antenne soit réglée en fréquence de manière à optimiser le fonctionnement de l'antenne en fonction du moteur électrique.

12. Antenne suivant la revendication 11 dans laquelle l'unité d'adaptation de fréquence comprend une unité de mise en forme de signaux.

13. Antenne suivant l'une quelconque des revendications 10 à 12 dans laquelle le cadre comprend un conducteur et un câble coaxial blindé de sorte que le conducteur se retourne sur lui-même de manière à former une ou plusieurs spires tandis que l'extrémité du câble conducteur est rattachée à l'écran du câble coaxial.

14. Procédé de diagnostic permettant de contrôler le fonctionnement des composants mécaniques et électriques associés à un moteur électrique, le procédé comprenant les étapes suivantes :
i) la détection de signaux radioélectriques à haute fréquence associés à des événements d'arc provenant d'un contact des balais dans le moteur électrique ;
ii) l'échantillonnage du signal à haute fréquence sur un laps de temps prédéterminé ;
iii) le traitement des données échantillonnées de manière à fournir des informations concernant les composants mécaniques et électriques du moteur électrique.

15. Procédé de diagnostic suivant la revendication 14 dans lequel le procédé fournit un moyen pour associer la fréquence du signal à haute fréquence à des composants individuels du moteur électrique.

16. Procédé de diagnostic suivant la revendication 14 ou 15 dans lequel la détection des signaux à haute fréquence utilise une antenne non intrusive.

17. Procédé de diagnostic suivant l'une quelconque des revendications 14 à 16 dans lequel l'échantillonnage fournit un moyen pour contrôler la modulation de fréquence et la modulation d'amplitude des signaux à haute fréquence.

18. Procédé de diagnostic suivant l'une quelconque des revendications 14 à 17 dans lequel le traitement des données échantillonnées comprend l'application de transformées de Fourier rapides de manière à convertir les données échantillonnées en spectres de fréquences interprétables.

19. Procédé de diagnostic suivant l'une quelconque des revendications 14 à 17 dans lequel le traitement des données échantillonnées comprend l'application de techniques de traitement de signal numérique sur les données échantillonnées de manière à convertir les données échantillonnées en spectres de fréquences interprétables.

20. Procédé de diagnostic suivant la revendication 19 dans lequel les techniques de traitement de signal numérique comprennent une analyse par ondelettes.

21. Procédé de diagnostic suivant l'une quelconque des revendications 18 à 20 dans lequel les spectres de fréquences interprétables comprennent des caractéristiques fréquentielles qui peuvent être directement associées à des diagnostics particuliers des composants mécaniques ou électriques du moteur électrique.

22. Procédé de diagnostic suivant l'une quelconque des revendications 18 à 21 dans lequel les spectres de fréquences interprétables comprennent des caractéristiques fréquentielles qui peuvent être directement associées à des défaillances mécaniques ou électriques particulières du moteur électrique.

23. Procédé de diagnostic suivant l'une quelconque des revendications 14 à 17 dans lequel le traitement des données échantillonnées comprend le calcul d'une largeur moyenne des signaux à haute fréquence, au-dessus d'un niveau prédéterminé, sur un certain nombre d'événements d'arc.

24. Procédé de diagnostic suivant l'une quelconque des revendications 14 à 17 dans lequel le traitement des données échantillonnées comprend le calcul d'une hauteur moyenne des signaux à haute fréquence sur un certain nombre d'événements d'arc.

25. Procédé de diagnostic suivant l'une quelconque des revendications 14 à 17 dans lequel le traitement des données échantillonnées comprend le calcul d'un rapport moyen de la largeur et de la hauteur des signaux à haute fréquence sur un certain nombre d'événements d'arc.

26. Procédé de diagnostic suivant l'une quelconque des revendications 14 à 25 dans lequel le procédé comprend une étape d'auto-étalonnage du procédé de diagnostic.

27. Procédé de diagnostic suivant la revendication 26 dans lequel l'auto-étalonnage du procédé de diagnostic comprend une technique de mesure de courant comprenant les sous-étapes suivantes :
i) la mesure du couple du moteur électrique en utilisant l'antenne non intrusive ;
ii) la mesure directe du courant dans le moteur électrique de manière à permettre que le couple du moteur électrique soit calculé ;
iii) le calcul de la différence entre les deux procédés pour obtenir la valeur du couple du moteur électrique, fournissant ainsi un facteur de compensation, et
iv) l'addition du facteur de compensation au procédé utilisant l'antenne non intrusive pour mesurer le couple du moteur électrique.
